# EUROPEAN PATENT SPECIFICATION

(11) **EP 0 753 855 B1**
(45) Date of publication and mention of the grant of the patent: **05.12.2001**
(21) Application number: 96102825.5
(22) Date of filing: 26.02.1996
(51) Int. Cl.: G11C 7/00

(54) **Data recording apparatus**
Vorrichtung zur Aufzeichnung von Daten
Dispositif d'enregistrement de données

(30) Priority: 13.07.1995 KR 9520595
(43) Date of publication of application: 15.01.1997
(73) Proprietor: Samsung Electronics Co., Ltd., Suwon-city, Kyungki-do 441-370 (KR)
(72) Inventor: Lee, Young-Man, Jangahn-Gu, Suwon-City, Kyungki-Do (KR)
(74) Representative: Tunstall, Christopher Stephen

(56) References cited:
- EP-A- 0 523 452
- EP-A- 0 523 519
- US-A- 5 218 640

## Description

The present invention relates to a data recording apparatus and method for a semiconductor memory card.

As semiconductor memory devices have become more highly integrated, various technologies have been proposed for storing voice data, song data and image data using small, thin and light memory cards as recording media.

An apparatus for recording song data using such a memory card is disclosed in U.S. Patent No. 4,813,014. In the data recording method used, in order to separate chapters of different songs, whenever a song is recorded, an end key is depressed and then a recording key is depressed. Thus, the end key and recording key are repeatedly operated for the various recordings, which is cumbersome work. Also, when several songs are consecutively recorded, if the end key is not pressed, the songs are not discernible.

US patent 5,218,640 describes a voice recorder which detects silent intervals, so that the beginning of a preceding passage of sound may be replayed without unnecessarily reproducing part of the previous recording.

It is an object of the present invention to provide an improved data recording apparatus and method for recording data in a semiconductor memory card.

Accordingly, the present invention provides a method of recording data on a memory card having a data area and a TOC area comprising:
recording a stream of audio data in a current chapter of the data area;
ending the recording operation if a sound-free section of the data stream of longer than a predetermined duration is detected;
when a further sound section of the data stream is detected once the recording operation has been ended, resuming recording the stream of audio data in a new chapter area of the memory card
the memory card also comprises a table of contents (TOC) area separate from the data area, and in that contents information comprising a new chapter number and a corresponding start address are stored in the table of contents (TOC) area of the memory card whereby several chapter numbers and corresponding start addresses can be stored in the table of contents area each corresponding to a sound section of the data stream stored in the data area.

The present invention also provides apparatus for recording data on a memory card having a data area comprising:
means for recording a stream of audio data in a current chapter of the data area;
means for ending the recording operation if a sound-free section of the data stream of longer than a predetermined duration is detected and resuming the recording of the stream of audio data in a new chapter area of the memory card when a further sound section of the data stream is detected once the recording operation has been ended;
the memory card also comprises a table of contents (TOC) area separate from the data area and in that the apparatus further comprises means for storing contents information comprising a new chapter number and a corresponding start address in the table of contents (TOC) area of the memory card whereby several chapter numbers and corresponding start addresses can be stored in the table of contents (TOC) area each corresponding to a sound section of the data stream stored in the data area.

The contents information may comprise pointer information including address information for the area in the table of contents (TOC) area where the start addresses of the new chapter are stored.

The contents information may comprise date, time and title information stored in the table of contents (TOC) area corresponding to each sound stream recorded in the data area.

The apparatus may include means for detecting sound and sound-free sections of a stream of audio data and outputting a detection signal.

The means for storing a new chapter number and a start address may be adapted also to store time information in the TOC area of the memory card.

The apparatus may include analog/digital converting means for converting a received analog audio signal into the stream of audio data in a digital form. The apparatus may include digital signal processing means for detecting sound and sound-free sections of the stream of audio data and outputting a detection signal and a compressed data stream.

Preferably the apparatus includes a keypad and controlling means for (a) generating time data corresponding to the period from a sound-free section of the data stream to another sound-free section according to the said detection signal, (b) if a recording command key is operated on the keypad, causing the time data and sound data to be recorded in a data transmission block, and (c) if a chapter selection key is operated on the keypad, automatically generating recording start and end signals in dependence upon the said detection signal.

The above objects and advantages of the present invention will become more apparent from the following detailed description of a preferred embodiment with reference to the accompanying drawings in which:
FIG. 1 is a block diagram of a data recording apparatus according to the present invention;

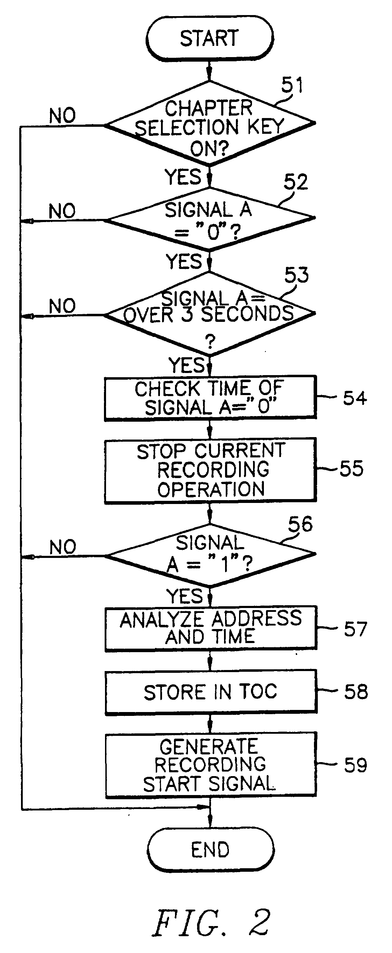

FIG. 2 is a flowchart showing the recording of data by automatically dividing chapters;
FIG. 3 is a waveform diagram of a sound/sound-free signal;
FIG. 4 is a data recording format of an IC memory card; and
FIG. 5 shows a data format for constituting a block in the unit of chapters and recording the same.

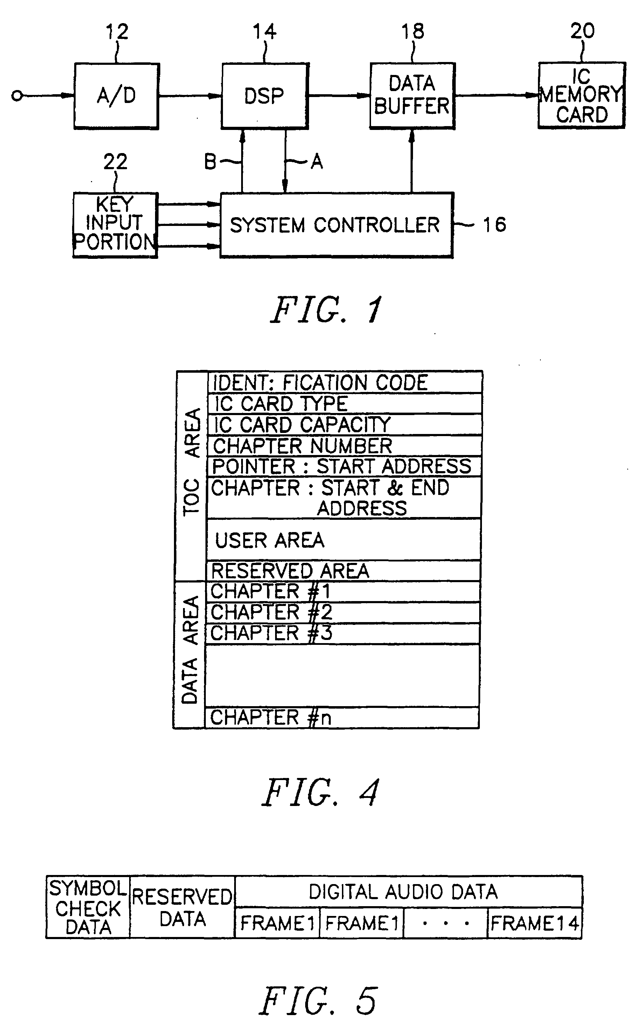

. As shown in FIG. 1, an analog/digital (A/D) converter 12 converts an analog audio data input, received from a mike or external device via an external input port 10, into a digital audio signal, to be output to a digital signal processor (DSP) 14. DSP 14 detects sound/sound-free sections of the input digital audio signal, compresses and outputs the digital audio signal. When data is read, the DSP 14 expands and outputs the compressed data. A key input portion (keypad 22) having numerical keys and various function keys such as a recording key, an end key and a chapter selection key, generates various commands, according to key inputs, and supplies them to a system controller 16.

System controller 16 generates time data corresponding to the time from a sound-free section to another sound-free section according to the sound/sound-free detection signal from DSP 14, and automatically generates a recording start signal according to the sound/sound-free detection signal. A data buffer 18 temporarily stores the data compressed by DSP 14 and table of content (TOC) area information output to the controller.

FIG. 4 shows a data recording format of an IC memory card which may be used with the present invention, which includes a TOC area in which TOC information is stored and a data area in which a plurality of programs corresponding to the TOC area are stored. TOC area includes an identification code, an IC card type, an IC card capacity, chapter numbers, pointers, chapters, a user area and a reserved area. The identification code is a 10-byte ASCII code for checking whether or not a currently inserted memory card is formatted properly. If an unformatted card is inserted, the system formats the currently inserted card.

The IC memory card type information indicates the memory type which may be mask ROM, dynamic random access memory (DRAM), static random access memory (SRAM) or flash memory. The 3-byte card capacity information indicates memory capacity. In other words, the memory capacity tells how many hours of data the recording medium will hold. The single byte chapter number indicates the number of currently recorded programs and a maximum of 128 programs are possible.

The chapter number indicates the range from the recording start initiated by pressing the recording key to a recording end. Thus, a single byte chapter number means that 128 recording operations are allowed. Since as many pointers as chapters are generated, the maximum memory required for the pointers is 128 bytes and the pointers area includes initial address information for the area where start and end address information of each chapter are stored. The chapter start and end address area has the corresponding information and occupies 128×6-byte capacity.

The user area has 128×15-byte capacity, and the information on year, month, date, time and minute and simple title information is stored therein during recording of each chapter. The reserved area corresponds to what is left from 4 Kbytes once the areas set out above are taken. The area following the 4 Kbyte area is the data area.

FIG. 5 shows a data format. The data consisting of each chapter includes single byte sound-free time data (symbol check data), 3-byte reserved data and digital audio data of 14 frames in a basic block.

A preferred embodiment of the present invention will be described in detail with reference to accompanying drawings.

If IC memory card 20 is loaded, the data in TOC area is read and the identification code is checked to allow a memory card which has not previously been used to be formatted. If the recording key is pressed in key input portion 22, system controller 16 recognizes a recording command to record the current data, time and minute in IC memory card 20. The last set pointer value is incremented to generate a new pointer. A value obtained by adding 1 to the end address value of the last recorded chapter is stored as a start address of a newly recorded program.

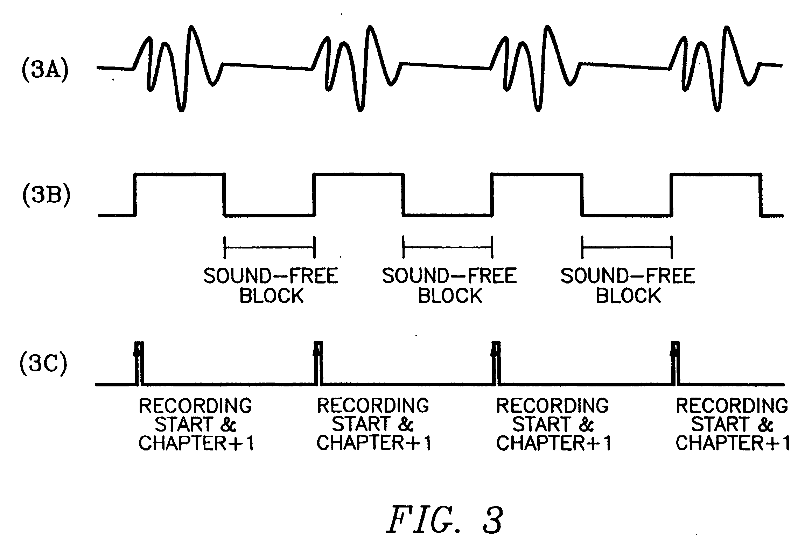

Thereafter, the analog audio signal input from a mike or external device via external input port 10 is converted into a digital audio signal in A/D converter 12 and then supplied to DSP 14. At this time, DSP 14 compresses 160 samples of the input audio data and generates a sound/sound-free signal A (FIG. 1), as shown in FIG. 3B with respect to the input audio signal shown in FIG. 3A, to be supplied to system controller 16.

System controller 16 receives the sound/sound-free signal A (FIG. 1) as shown in FIG. 3B to form a transmission block of 14 frames led by the sound-free time data and stores the data in the memory of IC memory card 20. The sound-free time data (symbol check data) represents a section without an audio signal, which is checked block by block to determine the time corresponding to the number of blocks. For example, assuming that sound-free sections last for four consecutive blocks and 20 milliseconds are assigned to each block, the sound-free section will last for 80 milliseconds.

Therefore, a hexadecimal number "00" corresponds to a sound section (no sound-free section). However, if there is a value, a sound-free section exists accordingly. In other words, if the hexadecimal number is "00," a decoding operation will immediately be performed without time delay. However, in other cases, the decoding operation is terminated for a length of time corresponding to the sound-free data. Then, after the sound-free interval ends, the decoding operation will again be performed.

Each frame is composed of 17-byte compressed data. The 17-byte compressed data is processed in units of 160 samples to be compressed by a linear prediction compression algorithm.

As described above, the audio data is recorded in IC memory card 20. After a reproduction key is input, in step 51, system controller 16 checks whether the chapter selection mode (activated by the chapter selection key on key input portion 22) is on or not. If the chapter selection mode is not on, the recording key is pressed as conventionally to start recording, the end key is pressed and then the recording key is again pressed. This is repeatedly performed, thereby recording audio data so as to divide chapters.

However, if the chapter selection mode is not,on, the process proceeds to step 52 to check whether or not the signal A shown in FIG. 3B, which is output from DSP 14 is a sound-free signal. If it is not a sound-free signal, the recording operation continues to be performed; if it is, the process proceeds to step 53. If the signal A of FIG. 3B is 1, it is a sound signal. If the signal A is 0, it is a sound-free signal.

In step 53, system controller 16 checks whether the sound/sound-free signal is detected as a sound-free signal for over three seconds; in other words, whether the time gap which is regarded to be enough to divide chapters is detected. At this time, if the sound-free signal is detected for over three seconds, the process proceeds to step 54. Then, system controller 16 clears the chapter division check time of the signal A of FIG. 3B to 0.

In step 55, system controller 16 ends the recording operation currently in progress and proceeds to step 56. In step 56, system controller 16 checks whether the signal as shown in FIG. 3B is detected again as the sound signal. If the sound signal is detected, the process proceeds to step 57. In step 57, system controller 16 analyzes the address of IC memory card 20, the current time when the sound signal is again detected, and incremented chapter number. Thereafter, in step 58, the analyzed result is stored in the TOC area of IC memory card 20, shown in FIG. 4 and the process proceeds to step 59.

In step 59, in order to start recording again, system controller 16 generates a recording start signal B shown in FIG. 3C to supply to DSP 14. Therefore, the aforementioned operations are repeatedly performed.

In the embodiment of the present invention, the chapter selection mode is turned on by operating the chapter selection key of key input portion 22. However, without departing from the scope of the present invention, the chapter division for an input audio signal can be implemented automatically such that the chapter selection state may be unconditionally turned on during recording time without a physical chapter selection key.

As described above, since the recording is performed so as to implement chapter division automatically in recording data in a semiconductor IC memory card, the repeated manipulation of an end key and a recording key is not necessary when a song is recorded.

## Claims

1. A method of recording data on a memory card (20) having a data area, comprising:
recording (59) a stream of audio data in a current chapter of the data area;
ending (55) the recording operation if a sound-free section of the data stream of longer than a predetermined duration is detected (53);
when a further sound section of the data steam is detected (56) once the recording operation has been ended, resuming (59) recording the stream of audio data in a new chapter area of the memory card,
**characterised in that** the memory card (20) also comprises a table of contents (TOC) area separate from the data area, and **in that** contents information comprising a new chapter number and a corresponding start address are stored (58) in the (TOC) area of the memory card;
whereby several chapter numbers and corresponding start addresses can be stored in the table of contents (TOC) area each corresponding to a sound section of the data stream stored in the data area.

2. Apparatus for recording data on a memory card (20) having a data area comprising:
means (12, 16, 18) for recording a stream of audio data in a current chapter of the data area;
means (14, 16) for ending the recording operation if a sound-free section of the data stream of longer than a predetermined duration is detected; and resuming the recording of the stream of audio data in a new chapter area of the memory card when a further sound section of the data stream is detected once the recording operation has been ended;
**characterised in that** the memory card (20) also comprises a table of contents (TOC) area separate from the data area, and **in that** the apparatus further comprises means (16, 18) for storing contents information comprising a new chapter number and a corresponding start address in the table of contents (TOC) area of the memory card whereby several chapter numbers and corresponding start addresses can be stored in the table of contents (TOC) area each corresponding to a sound section of the data stream stored in the data area.

3. An apparatus according to claim 2, **characterised in that** the contents information comprises pointer information including address information for the area in the table of contents (TOC) area where the start addresses of new chapters are stored.

4. An apparatus according to claim 2 or 3 **characterised in that** the contents information comprises date, time and title information stored in the table of contents (TOC) area corresponding to each sound stream recorded in the data area.

5. Apparatus according to any of claims 2 to 4 including means (14) for detecting sound and sound-free sections of a steam of audio data and outputting a detection signal.

6. Apparatus according to any of claims 2 to 5 in which the means (16, 18) for storing a new chapter number and a start address is adapted also to store time information in the table of contents (TOC) area of the memory card.

7. Apparatus according to any one of claims 2 to 6 including analog/digital converting means (12) for converting a received analog audio signal into the stream of audio data in digital form.

8. Apparatus according to any one of claims 2 to 7 including digital signal processing means (14) for detecting sound and sound-free sections of the stream of audio data and outputting a detection signal (A) and a compressed data stream.

9. Apparatus according to claim 8 including a keypad (22) and controlling means for (a) generating (57) time data corresponding to the period from a sound-free section of the data stream to another sound-free section according to the said detection signal, (b) if a recording command key is operated on the keypad, causing the time data and sound data to be recorded in a data transmission block, and (c) if a chapter selection key is operated (51) on the keypad, automatically generating (52-59) recording start and end signals in dependence upon the said detection signal.

## Patentansprüche

1. Verfahren zum Aufzeichnen von Daten auf einer Speicherkarte (20) mit einem Datenbereich, wobei in dem Verfahren:
ein Strom von Audiodaten in einem aktuellen Abschnitt des Datenbereichs aufgezeichnet wird (59);
die Aufzeichnungsoperation beendet wird (55), wenn ein tonloser Bereich des Datenstroms detektiert wird (53), dessen Dauer länger als eine vorgegebene Dauer ist;
die Aufzeichnung des Stroms von Audiodaten in einem neuen Abschnitt der Speicherkarte wieder aufgenommen wird (59), wenn, nachdem die Aufzeichnungsoperation beendet war, ein weiterer Tonbereich des Datenstroms detektiert wird (56),
**dadurch gekennzeichnet, dass** die Speicherkarte (20) auch einen Inhaltstabellenbereich (TOC) aufweist, der separat von dem Datenbereich ist, und dass Inhaltsinformation mit einer neuen Abschnittsnummer und einer entsprechenden Startadresse in dem (TOC) Bereich der Speicherkarte gespeichert werden (58) ;
wodurch mehrere Abschnittsnummern und entsprechende Startadressen in dem Inhaltstabellenbereich (TOC) gespeichert werden können, die jeweils einem Tonbereich des in dem Datenbereich gespeicherten Datenstroms entsprechen.

2. Vorrichtung zum Aufzeichnen von Daten auf einer Speicherkarte (20) mit einem Datenbereich, mit:
Mitteln (12, 16, 18) zum Aufzeichnen eines Stroms von Audiodaten in einem aktuellen Abschnitt in dem Datenbereich;
Mitteln (14, 16) zum Beenden der Aufzeichnungsoperation, wenn ein tonloser Bereich des Datenstroms detektiert wird, dessen Dauer länger als eine vorgegebene Dauer ist, und zum Wiederaufnehmen der Aufzeichnung des Stroms von Audiodaten in einem neuen Abschnitt der Speicherkarte, wenn, nachdem die Aufzeichnungsoperation beendet war, ein weiterer Tonbereich des Datenstroms detektiert wird;
**dadurch gekennzeichnet, dass** die Speicherkarte (20) auch einen Inhaltstabellenbereich (TOC) aufweist, der separat von dem Datenbereich ist, und dass die Vorrichtung weiter Mittel (16, 18) zum Speichern von Inhaltsinformation, die eine neue Abschnittsnummer und eine entsprechende Startadresse umfasst, in dem Inhaltstabellenbereich (TOC) der Speicherkarte aufweist, wodurch mehrere Abschnittsnummern und entsprechende Startadressen in dem Inhaltstabellenbereich (TOC) gespeichert werden können, die jeweils einem Tonbereich des in dem Datenbereich gespeicherten Datenstroms entsprechen.

3. Vorrichtung nach Anspruch 2, **dadurch gekennzeichnet, dass** die Inhaltsinformation weiter eine Zeigerinformation umfasst, die Adressinformation für den Bereich in dem Inhaltstabellenbereich (TOC) enthält, wo die Startadressen neuer Abschnitte gespeichert sind.

4. Vorrichtung nach Anspruch 2 oder 3, **dadurch gekennzeichnet, dass** die Inhaltsinformation Datums-, Zeit- und Titelinformation gespeichert in dem Inhaltstabellenbereich (TOC) entsprechend jedem Tondatenstrom, der in dem Datenbereich gespeichert ist, aufweist.

5. Vorrichtung nach einem der Ansprüche 2 bis 4, die Mittel (14) zum Detektieren von Ton enthaltenden und tonlosen Bereichen des Stroms von Audiodaten und zum Ausgeben eines Detektionssignals aufweist.

6. Vorrichtung nach einem der Ansprüche 2 bis 5, bei der die Mittel (16, 18) zum Speichern einer neuen Abschnittsnummer und einer Startadresse dazu vorbereitet sind, auch Zeitinformation in dem Inhaltstabellenbereich (TOC) der Speicherkarte zu speichern.

7. Vorrichtung nach einem der Ansprüche 2 bis 6, die eine Analog/Digital-Konvertereinrichtung (12) zum Konvertieren von empfangenen analogen Audiosignalen in einen Strom von Audiodaten in digitaler Form enthält.

8. Vorrichtung nach einem der Ansprüche 2 bis 7, die eine digitale Signalprozessoreinrichtung (14) zum Detektieren von Ton enthaltenden und tonlosen Bereichen des Stroms von Audiodaten und zum Ausgeben eines Detektionssignals (A) und eines komprimierten Datenstroms enthält.

9. Vorrichtung nach Anspruch 8, die eine Tastatur (22) und eine Steuereinrichtung (a) zum Erzeugen (57) von Zeitdaten entsprechend der Periode von einem tonlosen Bereich des Datenstroms zu einem anderen tonlosen Bereich nach Maßgabe des Detektionssignals, (b) zum Bewirken, wenn ein Aufzeichnungsbefehl auf der Tastatur betätigt wird, dass Zeitdaten und Tondaten in einem Datentransmissionsblock aufgezeichnet werden, und (c) zum automatischen Erzeugen (52 - 59), wenn eine Abschnittsauswahltaste auf der Tastatur betätigt wird (51), von Aufzeichnungsstart- und -endsignalen in Abhängigkeit von dem Detektionssignal umfasst.

## Revendications

1. Procédé d'enregistrement de données sur une carte mémoire (20) ayant une zone de données, comprenant :
l'enregistrement (59) d'un flot de données audio dans un chapitre courant de. la zone de données ;
la cessation (55) de l'opération d'enregistrement si une section exempte de son du flot de données plus longue qu'une durée prédéterminée, est détectée (53) ;
quand une section sonore supplémentaire du flot de données est détectée (56) une fois que l'opération d'enregistrement a été terminée, reprise (59) de l'enregistrement du flot de données audio dans une nouvelle zone de chapitre de la carte mémoire,
**caractérisé en ce que** la carte mémoire (20) comprend également une zone de table des matières (TOC) distincte de la zone de données, et **en ce que** des informations de contenu comprenant un nouveau numéro de chapitre et une adresse de début correspondante sont stockées (58) dans la zone (TOC) de la carte mémoire ;
de sorte que plusieurs numéros de chapitres et d'adresses de début correspondantes peuvent être stockés dans la zone de table des matières (TOC), chacun correspondant à une section sonore du flot de données stocké dans la zone de données.

2. Appareil pour l'enregistrement de données sur une carte mémoire (20) ayant une zone de données, comprenant :
un moyen (12, 16, 18) pour enregistrer un flot de données audio dans un chapitre courant de la zone de données ;
un moyen (14, 16) pour terminer l'opération d'enregistrement si une section exempte de son du flot de données plus longue qu'une durée prédéterminée, est détectée ; et pour reprendre l'enregistrement du flot de données audio dans une nouvelle zone de chapitre de la carte mémoire quand une section sonore supplémentaire du flot de données est détectée une fois que l'opération d'enregistrement a été terminée ;
**caractérisé en ce que** la carte mémoire (20) comprend également une zone de table des matières (TOC) distincte de la zone de données, et **en ce que** l'appareil comprend de plus un moyen (16, 18) pour le stockage d'informations de contenu comprenant un nouveau numéro de chapitre et une adresse de début correspondante dans la zone de table des matières (TOC) de la carte mémoire, de sorte que plusieurs numéros de chapitres et adresses de début correspondantes peuvent être stockés dans la zone de table des matières (TOC), chacun correspondant à une section sonore du flot de données stocké dans la zone de données.

3. Appareil selon la revendication 2, **caractérisé en ce que** les informations de contenu comprennent des informations de pointeur incluant des informations d'adresse pour la zone située dans la zone de table des matières (TOC) où les adresses de début de nouveaux chapitres sont stockées.

4. Appareil selon la revendication 2 ou 3,
**caractérisé en ce que** les informations de contenu comprennent des informations de date, de durée et de titre stockées dans la zone de table des matières (TOC) correspondant à chaque flot de son enregistré dans la zone de données.

5. Appareil selon l'une quelconque des revendications 2 à 4 comprenant un moyen (14) pour détecter des sections sonores et exemptes de son d'un flot de données audio et pour sortir un signal de détection.

6. Appareil selon l'une quelconque des revendications 2 à 5, dans lequel le moyen (16, 18) pour stocker un nouveau numéro de chapitre et une adresse de début est conçu pour stocker également des informations de durée dans la zone de table des matières (TOC) de la carte mémoire.

7. Appareil selon l'une quelconque des revendications 2 à 6, comprenant un moyen de transformation analogique/numérique (12) pour transformer un signal audio analogique reçu en flot de données audio sous forme numérique.

8. Appareil selon l'une quelconque des revendications 2 à 7, comprenant un moyen de traitement de signal numérique (14) pour détecter des sections sonores et exemptes de son du flot de données audio et pour sortir un signal de détection (A) et un flot de données comprimé.

9. Appareil selon la revendication 8 comprenant un clavier (22) et un moyen de commande pour (a) produire (57) des données de durée correspondant à la période allant d'une section exempte de son du flot de données à une autre section exempte de son selon ledit signal de détection, (b) si une touche de commande d'enregistrement est mise en oeuvre sur le clavier, pour provoquer l'enregistrement des données de durée et des données de son dans un bloc de transmission de données, et (c) si une touche de sélection de chapitre est mise en oeuvre (51) sur le clavier, pour produire automatiquement (52-59) des signaux de début et de fin d'enregistrement selon ledit signal de détection.
